# EUROPÄISCHE PATENTSCHRIFT

(11) **EP 0 977 907 B1**
(45) Veröffentlichungstag und Bekanntmachung des Hinweises auf die Patenterteilung: **04.08.2004**
(21) Anmeldenummer: 99911615.5
(22) Anmeldetag: 23.02.1999
(51) Int. Cl.: C23C 16/02, C23C 16/26, B05D 7/24

(54) **KOMBINIERTE VERSCHLEISSSCHUTZSCHICHT**
COMBINATION ANTIABRASION LAYER
COUCHE ANTI-USURE COMPOSITE

(30) Priorität: 26.02.1998 DE 19808180
(43) Veröffentlichungstag der Anmeldung: 09.02.2000
(73) Patentinhaber: ROBERT BOSCH GMBH, 70442 Stuttgart (DE)
(72) Erfinder: RAUSCHNABEL, Johannes, D-70197 Stuttgart (DE); FORGET, Jeanne, D-70195 Stuttgart (DE); VOIGT, Johannes, D-71229 Leonberg (DE)
(74) Vertreter: Isenbruck, Günter, Dr.
(86) Internationale Anmeldenummer: PCT/DE1999/000483
(87) Internationale Veröffentlichungsnummer: WO 1999/043865

(56) Entgegenhaltungen:
- EP-A- 0 718 418
- CA-A- 1 337 484
- DE-A- 4 441 313
- US-A- 5 679 413
- PATENT ABSTRACTS OF JAPAN vol. 013, no. 069 (C-569), 16. Februar 1989 & JP 63 259069 A (SUMITOMO ELECTRIC IND LTD), 26. Oktober 1988

## Beschreibung

### Stand der Technik

Praktisch alle Objekte sind durch Wechselwirkungen mit ihrer Umgebung einem mehr oder weniger ausgeprägten Verschleiß unterworfen. In der Regel führt dieser Verschleiß mit der Zeit zu einer Herabsetzung des Gebrauchswertes oder der Funktion der Objekte. Es war daher seit jeher das Bestreben, technische Bauelemente, d.h. Objekte mit einer technischen Funktion, so zu gestalten, daß sie bei bestimmungsgemäßem Einsatz möglichst wenig verschleißen und somit ihren Zweck möglichst lange erfüllen können.

Je nach der Art der Wechselwirkung mit ihrer Umgebung sind Bauelemente ganz unterschiedlichen Verschleißbeanspruchungen unterworfen, denen mit sehr unterschiedlichen Maßnahmen zu begegnen ist.

Bei Bauelementen, die keine nennenswerten Kräfte zu übertragen haben, tritt Verschleiß im wesentlichen durch Einwirkung von Licht, Luft, Wettereinflüsse und/oder Partikelbeschuß auf. Hier kommt es in erster Linie darauf an, die Gegenstände mit porenfreien, kratzfesten Oberflächen zu versehen. Eine in neuerer Zeit bekanntgewordene Möglichkeit, Oberflächen verschiedenster Art mit Polymerüberzügen zu versehen, besteht im Verfahren der Plasmapolymerisation. Bei diesem Verfahren wird mit verdampfbaren gesättigten oder ungesättigten Verbindungen im Feinvakuum durch elektrische Anregung ein Plasma erzeugt. In dem Plasma bilden sich aus den monomeren Verbindungen Fragmente, wie gasförmige Radikale, Radikal-Ionen, Ionen und angeregte Moleküle, die auf einem Substrat abgeschieden werden, auf dem sie eine hochvernetzte, einen dichten Überzug darstellende Polymerschicht bilden. Detaillierte Informationen zur Ausführung dieses Verfahrens finden sich beispielsweise in "Ullmanns Encyklopädie der Technischen Chemie", 5.Aufl., Bd.A20, Seiten 755 ff. und der dort angegebenen Literatur, "Comprehensive Polymer Sci. ", 4, S.357-375, und "Encycl.Polym.Sci.Enging., *11,* S. 248-261.

Eine interessante, auf diesem Verfahren beruhende Möglichkeit, auf Kunststoffe, wie Polymethylmethacrylat oder Polycarbonat, die beispielsweise bei der Herstellung von Autoscheinwerfern eingesetzt werden, eine transparente, kratzfeste Oberfläche aufzubringen, ist in "Bosch Technische Berichte" 8, (1986/87), von G. Benz unter dem Titel "Schutzschichten durch Plasmapolymerisation", publiziert im "Handbuch Plasmapolymerisation", VDI-Bildungswerk (1990), beschrieben worden. Gemäß dieser Veröffentlichung wird auf die Kunststoffoberfläche durch Plasmapolymerisation von HMDS(O) eine Plasmapolymerschicht erzeugt, die unmittelbar auf der Kunststoffoberfläche relativ weich ist, mit zunehmender Dicke immer härter wird und in eine harte, quarzähnliche Deckschicht mündet. Praktisch wird dieser Härtegradient dadurch erzeugt, daß die Plasmapolymerisation zunächst in Gegenwart von sehr wenig Sauerstoff ausgeführt wird und der SauerstoffPartialdruck mit zunehmender Schichtdicke immer weiter gesteigert wird.

Noch komplexer sind die Verhältnisse bei mechanischen Kraftübertragungssystemen, die Bauelemente aufweisen, die über die mechanische Beanspruchung, wie sie bei Streuscheiben für Scheinwerfer auftreten (Steinschlag, Abrasionsverschleiß) hinaus, besonders hohen und vielseitigen Beanspruchungen ausgesetzt sind. Solche Bauelemente sind Scherkräften, Schlagbeanspruchungen, hohen Druckkräften, und vor allem Gleitreibungskräften, sowie anhaltenden Schwingungseinwirkungen ausgesetzt, die entweder einzeln, in der Regel aber alle gleichzeitig, wenn auch in unterschiedlichem Ausmaß, auf die Elemente einwirken und zu einem mehr oder weniger schnellen Verschleiß führen.

Eine zunächst naheliegend erscheinende Lösung, alle Funktionselemente aus solchen Materialien herzustellen, die den unterschiedlichen Verschleißbeanspruchungen gewachsen sind, stößt auf erhebliche, oft unüberwindliche Schwierigkeiten, weil entweder solche Materialien gar nicht bekannt sind, oder weil an sich geeignete Materialien viel zu teuer sind oder nicht oder nur sehr schwierig zu den gewünschten Bauelementen zu formen bzw. zu bearbeiten sind.

Es ist daher schon vielfach versucht worden, auch Funktionselemente mechanischer Kraftübertragungssysteme aus gut verformbaren und möglichst auch preiswerten Materialien herzustellen und ihnen durch eine Oberflächenveredelung die erforderliche Verschleißresistenz zu vermitteln.
Je nach der Art der zum Verschleiß führenden Einwirkungen sind unterschiedliche Schutzmaßnahmen erforderlich. So ist es bekannt, z.B. Bohrer nicht nur mit Hartmetallschneiden zu versehen, sondern zusätzlich mit Hartstoffiiberzügen, wie z.B. Titannitrid, zu bedampfen. Bei hochbelasteten Kraftübertragungselementen werden an solche oberflächlichen Schutzschichten allerdings sehr hohe Anforderungen gestellt. So ist beispielsweise eine gute Adhäsion zum Bauelement, eine gute Kohäsion und möglichst geringe Spannungen innerhalb der Schicht, hohe Härte und Tragfähigkeit, ein möglichst geringer Reibungskoeffizient und gute Ober-flächenglattheit und eine möglichst geringe Adhäsion zum Gegenkörper er-wünscht. In der Regel können einheitliche Schichten aus Hartstoffen auf verschleißanfälligen Substraten die genannten Anforderungen in Kombination nicht erfüllen. Es ist daher bereits beschrieben worden, Kombinationsschichten zu erzeugen, die den Erfordernissen besser angepaßt werden können.

Aus der WO 95/16799 ist es bekannt, Bauteile zum Schutz gegen Verschleiß mit einer Hartstoffschicht zu versehen, die sich aus einer auf dem Bauteil aufliegenden Haftschicht einer darüber-liegenden Funktionsschicht und einer Oberflächenschicht zusammensetzt. Die Haftschicht besteht aus einem Titansystem, insbesondere aus Titanborid, oder, falls das Bauteil aus einem metallischen Substrat besteht, aus reinem Titan. Die Funktionsschicht besteht ihrerseits aus drei Schichten von Hartstoff-legierungen, Titannitriden, Titancarbiden und/oder Titanboriden unter-schiedlicher Zusammensetzung, beispielsweise aus Titannitrid, Titancarbonitrid und Titancarbid oder aus Titanboronitrid, Titanboronitridcarbid und Titan-borocarbid, mit allmählichen Übergängen der Zusammensetzungen zwischen den Schichten.

Die einzelnen Schichten werden durch sukzessives Aufdampfen der Titansysteme nach einem vorbestimmten Zeitplan auf das Substrat unter gleichzeitiger Einwirkung ernergiereicher, insbesondere schwerer, Ionen erhalten. Die Beschichtungstemperatur liegt bei diesem Verfahren bei ca. 200°C. Die Oberflächenschicht besteht aus einer metallhaltigen Kohlenstoffschicht (i-C(Ti)) und gegebenenfalls einer noch darüberliegenden metallfreien Kohlenstoffschicht (a-C:H).

Durch die Schichtabscheidung in Kombination mit der Schwerionenbestrahlung sollen sich Haftungs- und Schichttrennungsprobleme lösen lassen.

Aus der DE-A 44 41 313 sind Dichtungselemente für Absperr- und Regelorgane bekannt, bestehend aus einem platten-, kolben- oder kugelförmigen Absperrkörper aus einem metallischen oder nichtmetallischen Werkstoff, vorzugsweise aus Al₂O₃-Keramik, auf dessen Arbeitsfläche eine Hartstoffschicht aufgetragen ist. Die Hartstoffschicht besteht aus einer auf dem Keramikmaterial aufliegenden Haftschicht und einer darüber liegenden Gleitschicht. Die Haftschicht hat in den Übergangsbereichen zum Keramiksubstrat und zur Gleitschicht Zusammensetzungsgradienten, die einen möglichst fließenden Übergang der Zusammensetzung zwischen den Schichten bewirken.

Durch die dort beschriebene Maßnahme wird die Aufgabe gelöst, harte, formstabile Keramikbauteile, die normalerweise einen sehr hohen Haft- und Gleitreibungskoeffizienten aufweisen, mit einer gleitfähigen Oberfläche zu versehen, die aufgrund der eingefügten Haftschicht eine gute Heißwasserbeständigkeit aufweist. Die so beschichteten Keramikkörper können ohne Fettung der Gleitflächen als übereinandergleitende Dichtungselemente in Heißwasserarmaturen eingesetzt werden.

Die EP-A-0 718 418 (D2) betrifft ein Verfahren zur Herstellung von Gradientenschichten durch Plasmapolymerisation, bei dem die Zusammensetzung der Abscheidungsgase vorzugsweise konstant gehalten wird, die Plasmapolymerisation durch ein gepulstes Plasma herbeigeführt wird und der Gradient der gewünschten Schicht-Eigenschaft durch eine Variation der Pulslänge und der Pulspausen erzeugt wird.Als Vorteil dieses Verfahrens wird angeführt, daß es damit möglich ist, auch sehr dünne Gradientenschichten herzustellen, weil die Änderung der Schichtstruktur nicht von der relativ trägen Änderung der Zusammensetzung der Abscheidungsgase abhängt, sondern von der praktisch trägheitlosen Änderung der Pulsform des Plasmas.

Als Beispiele für den Einsatz dieses Verfahrens wird die Erzeugung von Schichten mit einer kratzfesten, quarzähnlichen Oberfläche genannt, die als Kratzschutzschichten auf Kunststoff-Brillengläsern und als Haftvermittler-Schichten geeignet sind.

Zur Herstellung dieser Schichten wird unter Einsatz eines Gasgemisches von HMDSO und Sauerstoff zunächst bei einer bestimmten Impulsform eine praktisch organische Schicht, anschließend bei Änderung der Impulsform eine praktisch anorganische Schicht abgeschieden.

Seit langem wird versucht, auch bei der Herstellung mechanisch belasteter Bauteile teure und/oder schwierig bearbeitbare Werkstoffe durch günstigere Materialien, z.B. Wälzlagerstahl, zu ersetzen. Im Rahmen dieser Bemühungen ist auch vielfach versucht worden, Bauteile mit technischer Funktion aus Kunststoffen zu fertigen. Kunststoffe haben nicht nur den Vorteil der preisgünstigen Zugänglichkeit, sie sind auch in großer Vielfalt- erhältlich, lassen sich in beinahe beliebige Formen bringen und sie haben vorteilhafte physikalische Eigenschaften, z.B. eine günstige innere Dämpfung, wodurch sie nur wenig zur Erzeugung, zur Übernahme (Resonanz) und zur Weiterleitung von Schwingungen neigen. Diese Eigenschaft beugt nicht nur einem Ermüdungsverwhleiß vor, sondern führt auch zu besonders geringen Arbeitsgeräuschen.

In Fällen, in denen keine nennenswerten mechanischen Belastungen auftreten, ist es auch gelungen, beispielsweise durch die oben beschrieben Aufbringung einer Kratzschutzschicht aus SiO₂, einen ausreichenden Oberflächenschutz herzustellen.

Im Falle mechanisch belasteter Bauteile sind die Verschleißeigenschaften der günstigeren Materialien aber oft ungenügend. In diesen Fällen wird, wie oben dargelegt, versucht, durch eine dünne Beschichtung die erforderliche Verschleißresistenz der Bauteile zu erreichen. Im Falle von Kunststoffen als kostengünstigem Material für verschleißbeanspruchte Bauteile, z.B. bei Zahnrädern oder Rutschkupplungen, müssen auf diese Bauteile harte Schichten aufgebracht werden.

Da bei vielen Materialien, insbesondere auch bei Kunststoff, die thermische Belastbarkeit für den Beschichtungsprozeß eine Rolle spielt, ist es erforderlich, Beschichtungsverfahren einzusetzen, die bei relativ niedrigen Temperaturen ausgeführt werden und bei denen die Schichtabscheideraten groß genug sind. Viele Beschichtungsverfahren, die bei der Veredelung von Metalloberflächen in Gebrauch sind, scheiden daher für die Beschichtung von Kunststoffen aus.

Ferner zeigt es sich, daß durchgehend harte Schichten zu spröde sind und bereits bei kleinen Druckbeanspruchungen, wie sie bei den meisten Verschleißbeanspruchungen vorkommen, von Kunststoffsubstraten abplatzen. (In der Literatur wird dieses Verhalten als "Eierschaleneffekt" bezeichnet.) Zur Überwindung dieses Mangels ist es notwendig, innerhalb der Schicht einen Härtegradienten zu realisieren, d.h. daß die Schichthärte so eingestellt werden muß, daß sie von der weich-elastischen Kunststoffbasis bis zur harten Deckschicht, die dem Verschleiß ausgesetzt wird, graduell zunehmend ist. Dieses Prinzip ist bei der oben genannten, von Bosch beschriebenen Beschichtung von Kunststoffen mit einer transparenten SiO₂-Kratzschutzschicht realisiert worden.

Diese bekannten Plasmapolymerschichten mit Härtegradient haben den Nachteil, daß sie anderen Verschleißbeanspruchungen, insbesondere Gleitverschleißbeanspruchungen ungenügend widerstehen. Ihr Vorteil liegt im wesentlichen im Kratzschutz für relativ weiche Kunststoffbauteile und in der Transparenz der Schichten, sodaß die Beschichtung auch für optische Anwendungen in Frage kommt.

Amorphe Kohlenstoffschichten zeigen ausgezeichnete Verschleißschutzeigenschaften bei hoher Härte. Sie bestechen außerdem durch einen sehr niedrigen Reibungskoeffizienten bei Gleitverschleißuntersuchungen. Diese Schichten können aber noch nicht in den Abscheideraten-Größenordnungen aufgebracht werden, wie sie von der Plasmapolymerisation her bekannt sind.

Metallhaltige Kohlenstoffschichten, z.B. i-C(WC), weisen ebenfalls einen guten Gleit- und Schwingverschleißschutz auf, können aber wegen der im Vergleich zu einem Plasmapolymer-Beschichtungsprozeß ebenfalls deutlich geringeren Abscheiderate und der hohen thermischen Belastung nur auf wenige, meist teure Kunststoffsorten appliziert werden. Hinzu kommt, daß zum Schutz gegen Schlagverschleißbeanspruchung besonders dicke und in ihrem Elastizitätsmodul genau abgestimmte, angepaßte Schichtsysteme notwendig wären, wie sie mit reiner Kohlenstoffbeschichtung auf üblichen Kunststoffsorten nicht aufgebracht werden können.

Die Abscheidung von Härtegradientenschichten ist bei Kohlenstoffsystemen zwar möglich, kann aber auf sehr weiche Substrate, insbesondere auf Kunststoffe, nicht angepaßt werden, da die dazu nötigen, sehr weichen graphitähnlichen Kohlenstoffschichten an der Schichtbasis mechanisch ungenügend belastbar sind, d.h. unter Normal- und Scherbelastung schlechte Haftung zeigen.

### Vorteile der Erfindung

Es wurde nun gefunden, daß es überraschenderweise möglich ist, bestimmte Hartstoffschichten, insbesondere solche auf Basis von metallhaltigem und metallfreiem Kohlenstoff über eine Plasmapolymer-Stützschicht mit definierten Härte- und Elastizitätseigenschaften mit Oberflächen weicher Materialien, insbesondere mit Kunststoffoberflächen fest und dauerhaft zu verbinden.
Die erfindungsgemäß mit Hartstoffschichten überzogenen Materialien weisen vorzügliche Verschleißeigenschaften auf.

Die Deckschicht - beispielsweise eine Kohlenstoffschicht, die metallhaltig oder metallfrei aufgebaut werden kann - bestimmt vorwiegend den Gleit-, Schwing- und Abrasivverschleißschutz der Kombischicht, während die Stützschicht Einfluß auf den Schlagverschleißschutz des Schichtpakets hat, sodaß insgesamt ein sehr guter Schutz gegen Gleit- und Ermüdungsverschleiß auch an tribologisch hochbelasteten Bauteilen erreicht wird. Die Deckschichten der erfindungsgemäßen Schutzüberzüge haben aufgrund ihres Kohlenstoffanteils eine sehr gute Affinität zu Schmiermitteln, sodaß Schmierfilmabrisse weitgehend vermieden werden. Darüberhinaus zeigen Kohlenstoffschichten Trockenschmiereigenschaften, d.h. Schichtabrieb kann auf dem Tribopartner eine Art Schmierbuchse erzeugen. Sie können außerdem in ihrer Topographie (Körnung, Rauhtiefe, Porosität) so variiert werden, daß einerseits eine sehr gute Resistenz gegen Kavitationsverschleiß erreicht, andererseits ein Festfressen gleitender Flächen vermieden wird.

Durch Nutzung der Plasmapolymerschicht in diesem Mehrebenen-Schichtaufbau wird es möglich, Härte- und Elastizitätsmodule zwischen Substrat und Verschleißschutzschicht anzupassen, was in einer höheren Duktilität und einer sehr guten Haftung der Schichten auch auf weichen Kunststoffen resultiert.

Die beim Plasmapolymerprozeß möglichen hohen Abscheideraten ermöglichen kurze Prozeßzeiten, die wiederum größeren Stückdurchsatz bei gleichbleibender Grundinvestition erlauben. Das bedeutet, daß die Abschreibung der Anlageninvestition sich auf mehr Bauteile verteilt und damit den Stückpreis senkt.

Durch den Einsatz von Plasmapolymer-Stützschichten kann somit kostengünstig und bei relativ niedrigen Beschichtungstemperaturen gearbeitet werden. Dies ist für Massenbauteile, z.B. den Kunststoffzahnrädern von Stellgetrieben, oder von Elektrowerkzeug-Getrieben, wegen der damit verbundenen Beschichtungskosten besonders wichtig.

Die erfindungsgemäße kombinierte Verschleißschutzschicht für Bauelemente aus verschleißanfätligen Substraten, insbesondere aus Kunststoffen oder weichen Metallen, besteht aus einer verschleißfesten Deckschicht und einer zwischen Substrat und Deckschicht liegenden Stützschicht, die über ihre Dicke einen Übergang von der auf dem Substrat aufliegenden relativ weichen Basisebene der Stützschicht auf Eigenschaften der Deckschicht vermittelt, und ist dadurch gekennzeichnet, daß die Deckschicht eines oder mehrere der Elemente Kohlenstoff, Stickstoff, Silicium oder Bor enthält, wobei der Anteil des Kohlenstoffs, des Stickstoffs oder des Bors oder, sofern mehr als eines dieser Elemente vorhanden ist, die Summe der Anteile dieser Elemente mindestens 30 Atom-%, vorzugsweise mindestens 40 Atom-% beträgt, daß die Stützschicht aus einem Plasmapolymer, das aus einer silicium-organischen Verbindung und/oder einer aliphatischen und/oder einer aromatischen Kohlenstoffverbindung abgeschieden wurde, besteht und daß die Stützschicht einen quasi-stetigen Übergang des Elastizitätsmoduls und gegebenenfalls der Härte von dem Wert der Basisschicht auf den Wert der Deckschicht aufweist.

Ein "quasi-stetiger Übergang" im Sinne dieser Erfindung bedeutet, daß der Elastizitätsmodul und/oder die Härte entweder über die Dicke der Schicht einen Gradienten bildet, der in einer geschlossenen Kurve darstellbar ist, wobei diese Kurve nicht an allen Punkten die gleiche Steigung haben muß, aber keine festigkeitsrelevante Unstetigkeitsstelle, d.h. keinen erheblichen Bruch aufweisen darf, oder daß ein vielstufiger Übergang von der weichen Basis zur harten Deckschicht durch ein Paket aus einer Vielzahl einzelner Schichten erzeugt wird, deren Elastizitätsmodul und/oder Härte sich von Schicht zu Schicht geringfügig und zielgerichtet ändert.

Die Zusammensetzung der Deckschicht wird so gewählt, daß sie hart ist und/oder reibmindernde und/oder trockenschmierende Eigenschaften besitzt und das Substrat gegen mechanischen Verschleiß schützt.

Die Schichten und Schichtebenen, können über die oben genannten Elemente hinaus weitere Elemente, vorzugsweise Wasserstoff, Sauerstoff und Metalle enthalten.

Insbesondere in der Deckschicht können Metalldotierungen zur Modifizierung der Schichteigenschaften und damit zur optimalen Anpassung an den vorgesehenen Anwendungsbereich eingesetzt werden.

Vorzugsweise besteht die Deckschicht ganz oder überwiegend, insbesondere zu über 60 Atom-% aus Kohlenstoff und bis zu 40 Atom-% aus Stickstoff, Bor, Silicium und/oder Metallen.

Besonders bevorzugt sind Deckschichten, die über 75 Atom-%, insbesondere über 85 Atom-% Kohlenstoff aufweisen.

Besonders bevorzugt sind ferner Deckschichten, die mindestens 60 Atom-% Kohlenstoff in Kombination mit mindestens 2, vorzugsweise mindestens 10, insbesondere mindestens 20 Atom-% eines der oben genannten Elemente, Stickstoff, Silicium, Bor oder Metalle, enthalten.

Die anwendungstechnisch so wertvollen Eigenschaften der erfindungsgemäßen Schutzschichten ergeben sich aus dem Zusammenwirken der mechanischen Eigenschaften von Stützschicht und Deckschicht, die ihrerseits auf deren stofflicher Zusammensetzung und der sich unter den Abscheidungsbedingungen ergebenden Struktur beruhen.

Die Plasmapolymerschichten der erfindungsgemäßen Verschleißschutzschichten bestehen aus hochvemetzten Polymermassen, die eine mehr oder weniger statistische Struktur aufweisen, d.h., daß in ihnen die an ihren Aufbau beteiligten Atome nicht, wie bei einfachen Monomeren oder Polymeren, in einem einfachen ganzzahligen Verhältnis zueinander stehen müssen. Daher können in den Summenformeln gebrochene, voneinander unabhängige Atomindices vorkommen wie z.B. Si C_{1,9} N_{0,3} H_{0,1} H_{1,1}. Dies hat den großen Vorteil, daß es gelingt, die stöchiometrische Zusammensetzung der Polymerschicht in den verschiedenen Ebenen nach Bedarf einzustellen und gewünschtenfalls über die Schichtdicke kontinuierlich oder in festigkeitsunschädlich kleinen Schritten zu verändern.

Die Komponenten Stickstoff, Bor, Silicium und Metalle bilden mit dem Kohlenstoff und untereinander Systeme, in denen alle unter den Bedingungen der Schichtbildung mögliche Phasen vorliegen können. So können Stickstoff, Bor und Silicium teils in die räumlich vernetzte Struktur des Plasmapolymers eingebaut sein oder beispielsweise als Nitrid- oder Carbidphasen oder als Mischphasen daraus vorliegen.

Metalle können je nach den Abscheidungsbedingungen ebenfalls in das Polymer eingebunden sein, oder als Nitrid-, Carbid-, oder Boridphasen, aber auch in ungebundener Form vorliegen.

Im Hinblick auf die Vielfalt der in den einzelnen Ebenen der Stützschicht und der Deckschicht möglichen Strukturen konnte der Fachmann die hervorragenden Eigenschaften der erfindungsgemäßen Verschleißschutzschichten nicht vorhersehen.

Zur Modifizierung, insbesondere der Deckschicht-Eigenschaften, eignen sich im Prinzip alle Metalle mit Ausnahme der der 1. Hauptgruppe des periodischen Systems. Zweckmäßigerweise werden Metalle der zweiten bis fünften Periode der Hauptgruppe 3, die Metalle der vierten bis sechsten Hauptgruppe und die Nebengruppenmetalle eingesetzt. Bevorzugt sind Metalle der Nebengruppen, insbesondere solche der vierten Periode. Besonders bevorzugt sind Tantal, Titan, Wolfram und Chrom.

Als Metallverbindungen kommen insbesondere Metallcarbide, und/oder - Nitride und/oder -Carbonitride und/oder -Boride und/oder -Boronitride der oben genannten Metalle in Betracht. Der Anteil der Metallatome und/oder Metallverbindungen, bezogen auf Metall, in der Deckschicht beträgt bis zu 40 Atom-%. Vorzugsweise liegt er im Bereich von 1 bis 30, insbesondere von 5 bis 30 Atom-%.

Auch die Plasmapolymer-Stützschicht kann Metallatome oder Metallverbindungen enthalten, insbesondere dann, wenn es zu Anpassung ihrer physikalischen Daten an die der Deckschicht zweckmäßig ist. Die Basisebene der Stützschicht besteht zweckmäßigerweise aus einem Plasmapolymerisat, das eine hohe Adhäsion zum Material des Substrats hat. Dies kann beispielsweise dadurch erreicht werden, daß die Basisebene der Stützschicht aus einem Plasmapolymerisat besteht, das bezüglich seines Elastizitätsmoduls, seiner Härte und seiner Verformbarkeit mit dem Material des Substrats eine zur Erzielung einer guten Haftung ausreichende Übereinstimmung aufweist.
Für die Erzielung besonders guter Haftungseigenschaften zwischen Stützschicht und relativ weichen Substraten hat es sich als zweckmäßig erwiesen, daß die Basisebene der Stützschicht aus einem Plasmapolymerisat besteht, dessen stöchiometrische Zusammensetzung nur wenig von der stöchiometrischen Zusammensetzung des zugeführten Monomers abweicht. Vorzugsweise besteht die Basisebene der Stützschicht aus einem Plasmapolymerisat einer silicium-organischen Verbindung.

Weitere Kriterien, die eine gute Haftung zwischen Basisebene der Stützschicht und Substrat begünstigen, bestehen darin, daß die Basisebene der Stützschicht aus einem Plasmapolymerisat besteht, das gleiche oder ähnliche funktionelle Gruppen aufweist wie das Material des Substrats oder dessen funktionelle Gruppen mit Substituenten an der Substratoberfläche in Wechselwirkung treten können. Sofern ein weiches Metall erfindungsgemäß beschichtet werden soll, ist es vorteilhaft, wenn die Basisebene der Stützschicht aus einem Plasmapolymerisat besteht, das metallaffine, polare Gruppen enthält. Es ist natürlich auch möglich, zwischen der Oberfläche des Substrats und der Basisebene der Stützschicht eine zusätzliche haftvermittelnde Schicht anzubringen aus einem Material, das Affinität sowohl zum Substrat, als auch zum Material der Basisebene der Stützschicht hat. Eine solche Haftvermittlerschicht hat zweckmäßigerweise eine Dicke von 5 bis 100 nm, vorzugsweise von 10 bis 50 nm.

Für die Erzielung besonders guter Verschleißschutz-Eigenschaften der Deckschicht hat es sich als zweckmäßig erwiesen, daß die Stützschicht zumindest in einem Schichtebenen-Bereich direkt unterhalb der Deckschicht einen Gradienten ihrer stöchiometrischen Zusammensetzung aufweist, der in der stöchiometrischen Zusammensetzung der Deckschicht mündet, da dies in der Regel einen fließenden Übergang der Elastizitätseigenschaften von der Stützschicht zur Deckschicht zur Folge hat.

Beispielweise kann im Falle einer erfindungsgemäßen Schutzschicht mit einer Kohlenstoff-Deckschicht eine elastische, haftfeste Stützschicht dadurch erzielt werden, daß der Kohlenstoffgehalt, von dem der Basisebene ausgehend, mit zunehmender Schichtdicke bis zu dem der Deckschicht zunimmt. Der Übergang von der Stöchiometrie und dem Elastizitätsmodul der Plasmapolymerschicht zur der der Kohlenstoffschicht ist somit fließend oder erfolgt in einer Vielzahl niedriger Stufen.

Beispielsweise besteht die Schichtbasis aus einem Si-C-Plasmapolymer, bzw. einem Si-C-O-Plasmapolymer, darauf folgt ein Kohlenstoffgradient, der bis hin zur Kohlenstoff-Deckschicht geht. Naturgemäß bildet dann der Summengehalt der anderen Schichtbestandteile einen dem Kohlenstoffgehalt entgegengesetzten Gradienten, da die Summe aller Bestandteile stets 100 % betragen muß.

Wichtigstes Kriterium einer guten erfindungsgemäßen Verschleißschutzschicht ist der quasi-stetige Übergang der Elastizitäts- und gegebenenfalls der Härte-Daten von der Basisebene der Stützschicht bis zur Deckschicht. Dieser Übergang muß nicht unbedingt durch einen von der Basisebene bis zur Deckschicht verlaufenden kontinuierlichen Übergang des Kohlenstoffgehalts oder des Gehalts eines einzelnen anderen Schichtbestandteils herbeigeführt werden. Es können auch mehrere der Schichtbestandteile, wie z.B. Kohlenstoff, Sauerstoff, Stickstoff oder Bor, gleichgerichtete Gehaltsgradienten aufweisen, wenn die restlichen Bestandteile in ihrer Summe einen entgegengesetzten gleichgroßen Gehaltsgradienten ergeben. Weiterhin ist es möglich, und je nach der Zusammensetzung der Basisebene und der Deckschicht eventuell auch besonders zweckmäßig, den kontinuierlichen Übergang der Elastizitätseigenschaften von der Basisebene zur Deckschicht durch eine Abfolge von Konzentrationsgradienten verschiedener Schichtbestandteile in verschiedenen Schichtebenen-Bereichen zu realisieren. Beispiele für solche abgestuften Gehaltsgradienten sind folgende Schichtaufbauten:

Die Basisebene bildet ein Si-C-O-Plasmapolymer, das von einem Sauerstoffgradient gefolgt wird. Daran schließt sich ein Übergang zu hohem Stickstoffgehalt an und von diesem aus folgt über einen Kohlenstoffgradient die Kohlenstoff-Deckschicht.

In einer anderen Ausführungsform besteht die Basisebene der Stützschicht aus einem Si-C-N-Plasmapolymer, geht in einem Gradienten zu hohem Stickstoffgehalt über und diesen ablösend folgt ein Übergang zu hohem Kohlenstoffgehalt, der in einer Kohlenstoff-Deckschicht endet.

Bei einem weiteren beispielhaften Schichtaufbau besteht die Basisebene aus einem Si-C-O-Plasmapolymer, bzw. einem Si-C-N-Plasmapolymer, danach folgt ein Gradient mit Stickstoff oder Bor, der in eine Bornitrid-, bzw. eine Si-N-B-Deckschicht mit oder ohne Kohlenstoff übergeht. Alle diese Varianten können, wie oben bereits beschrieben, in der Stützschicht, insbesondere aber in der Deckschicht Metallatome oder Metallverbindungen, wie z.B. TiN, enthalten.

Dotierungen mit Si-, B-, N-, O- oder beliebigen Metallatomen in einer Kohlenstoff-Deckschicht sind ebenfalls möglich.

Die Erzeugung der erfindungsgemäßen Verschleißschutzschichten erfolgt durch die an sich bekannte Plasmapolymerisation. Gewünschtenfalls kann gleichzeitig oder anschließend auch eine PVD-Abscheidung, z.B. in einem Sputterprozeß durchgeführt werden. Erfindungsgemäß wird die Plasmapolymerisation in der Weise durchgeführt, daß, gegebenenfalls nach Auftrag einer Haftvermittlungsschicht oder nach einer Plasmafeinreinigung (Plasmaätzung) und/oder Plasmaaktivierung der Substratoberfläche, dem Plasma ein Monomergas oder ein Monomergas-Gemisch, bestehend aus einer oder mehreren gasförmigen siliciumorganischen Verbindungen und/oder aliphatischen und/oder aromatischen Kohlenstoffverbindungen und gegebenenfalls weiteren, Dotierungselemente enthaltenden Verbindungen zugeführt wird, wobei es zu einer plasmainduzierten Abscheidung einer sich vernetzenden Polymerschicht auf dem Substrat kommt. Dabei werden die Polymerisationsbedingungen und die Monomergas-Zusammensetzung zweckmäßigerweise nach einem in Vorversuchen ermittelten, vorbestimmten Programm so gewählt, daß sich in jeder beim Aufbau der Schicht erreichten Schichtebene die dafür vorgesehene stöchiometrische Zusammensetzung ergibt.

Es hat sich in vielen Fällen als vorteilhaft erwiesen, die Polymerisationsbedingungen zu Beginn des Abscheidungsprozesses so zu wählen, daß die weiche Schichtbasis in ihrer Stöchiometrie der des eingesetzten Monomers nahekommt.

Zum Aufbau der Plasmapolymerschichten eignen sich im Prinzip alle Verbindungen mit bei Temperaturen zwischen 20 und 200°C ausreichendem Dampfdruck, wobei als ausreichend Dampfdrücke von etwa 10 bis 0,001 mbar anzusehen sind.

Bevorzugt als Monomer für den Aufbau der erfindungsgemäßen Verschleißschutzschicht sind in der Regel Organosiliciumverbindungen, auch solche mit Sauerstoff-, Stickstoff- oder Borgehalt. Geeignete derartige Verbindungen finden sich in der Klasse der Poly(organosilane), der Poly(siloxane), der Poly(carbosilane), der Poly(organosilazane) und der Poly(carbosilazane). Beispiele derartiger Monomerer sind Tetramethyl-monosilan, Tetraethylmonosilan, Methyl-diphenyl-monosilan, Trimethyl-monosilanol, Diethoxydimethyl-monosilan, oder Hexamethyl-cyclotrisiloxan. Besonders bevorzugt als Silicium enthaltendes Monomermaterial sind Vertreter der Poly(organosilane) und der Poly(siloxane), insbesondere Hexamethyl-disilan (HMDS), Hexamethyl-disiloxan (HMDSO), Tetraethyl-orthosilikat (TEOS) und Divinyltetramethyl-disiloxan (VSi₂).

Als Monomergase für die Abscheidung von C-H-Schichten kommen gesättigte oder ungesättigte, verzweigte oder unverzweigte aliphatische Kohlenwasserstoffe, zweckmäßigerweise solche mit 1 bis 8, vorzugsweise mit 1 bis 4 Kohlenstoffatomen, oder aromatische Kohlenwasserstoffe, vorzugsweise mit 6 bis 14 Kohlenstoffatomen, in Betracht. Beispiele für geeignete Kohlenwasserstoffe sind Alkane, z.B. Methan, Ethan, Propan, Butan, Isobutan, Octan, Isooctan, Alkene, z.B. Ethen, Propen, Alkine, z.B. Acetylen, und Aromaten, z.B. Benzol, Toluol, Xylol. Bevorzugte Kohlenwasserstoffe sind Methan, Ethen und Acetylen.

Sollen andere Elemente als C,H und Si in das Plasmapolymer eingebaut werden, so können im Prinzip Monomere auf der Basis der oben genannten Klassen eingesetzt werden, die diese zusätzlichen Elemente als Substituenten oder als Kettenglieder enthalten. Aus Kostengründen ist es jedoch viel günstiger, diese Elemente durch Zusatz einfacher, vergasbarer Verbindungen dieser Elemente zu dem Gasstrom, der dem Plasma zugeführt wird, statistisch in das erzeugte Plasmapolymer einzubauen. So lassen sich Sauerstoff- und Stickstoffanteile in das Polymer durch Zusatz von Sauerstoff, Stickstoff, Ammoniak oder Lachgas einführen. Beispielsweise kann die graduelle Anpassung der Stöchiometrie der Stützschicht an eine Kohlenstoff-Deckschicht über die Zugabe von kohlenstoffhaltigen Zusatzgasen, wie z.B. Methan, Ethylen oder Acetylen zum Monomergas-Strom erfolgen. Zum Einbau anderer Elemente in das Polymer und zur Realisierung der Gehaltsgradienten eignen sich außer Sauerstoff, Stickstoff, Ammoniak, Methan, Ethylen, oder Acetylen, auch Borverbindungen, wie Borsäureester, Boranole oder Borane und Stickstoff in Form von Amino- oder Amidogruppen enthaltenden Verbindungen, wie z.B. Acrylnitril und Sauerstoff in Form von Wasser, oder Mischungen aus den genannten Substanzen, sowie vergasbare Metallverbindungen, vorzugsweise aus der Reihe der Metallniederalkoxide wie Aluminium-, Zirkon- und Titanalkoxide, beispielsweise Tetra-tert.butyloxyzirkon, Tetra-tert.butyloxy-titan, Triethoxy-aluminium und aus der Reihe der Metallcarbonyle wie z.B. Wolframhexacarbonyl.

Mit besonderem Vorteil können aber Metall- und Nichtmetalldotierungen der erfindungsgemäßen Verschleißschutzschicht durch eine mit dem Plasmapolymerisationsprozess parallel laufende oder anschließend daran ausgeführte PVD-Abscheidung erzeugt werden, für die ein Sputterprozeß, beispielsweise das Magnetronsputtern, das Pulsmagnetronsputtern, das Gleichstromsputtern, das Hochfrequenzsputtern oder das Hohlkathoden-Gasflußsputtern zur Anwendung kommen kann.

In diesem Fall können beliebige Metall- und Nichtmetall-, Oxid-, Borid-, Carbid-, Silicid- oder Nitrid-Targetmaterialien zum Einsatz kommen.

Struktur und Zusammensetzung der erfindungsgemäßen Verschleißschutzschichten und deren Ebenen lassen sich nicht nur durch die Art und das Mengenverhältnis der Monomergase regeln, sondern auch durch die Prozeßbedingungen. So ist es auch möglich, über eine fließende Änderung der Prozeßbedingungen zu Gunsten eines höheren Kohlenstoffgehalts einen kontinuierlichen Übergang von der Zusammensetzung und Struktur einer Basisebene zu einer Kohlenstoff-Deckschicht zu erzielen. Prozeßbedingungen, die zur Regelung von Stärke, Struktur und Zusammensetzung der Schichtebenen vorgegeben werden können, sind der Prozeß-Gesamtdruck, der Monomeren-Partialdruck, die Strömungsgeschwindigkeit des Gasgemisches und damit zusammenhängend die Monomerfluß-Rate, die Temperatur von Gasmischung und Substrat, die Abstände und die Geometrie von Gaseinlaß, Plasmabereich und Substrat, die Plasmaenergie sowie die Anregungsfrequenz, und die Beschichtungsdauer. Besonders wirksame Beeinflussungsmöglichkeiten für die Schichtstruktur bieten die Plasmaenergie, die Arbeitstemperaturen, der Substratabstand und die Druckverhältnisse. So führt Erhöhung der Plasmaenergie und die Erhöhung der Substrattemperatur zu härteren Polymerabscheidungen, Erhöhung des Prozeßdruckes zu weicheren Abscheidungen mit geringerer Dichte. Die Wahl des Abstands zwischen Plasma und Substrat, des Sauerstoff- bzw. Reaktivgasanteils im Gasgemisch, der Plasmaleistung und der Substrattemperatur läßt sich auch zur Einstellung einer gewünschten Topographie der Polymerschichten insbesondere der Deckschicht einsetzen. Herabsetzung des Sauerstoff- bzw. Reaktivgasanteils, Herabsetzung der Plasmaleistung, Herabsetzung der Substrattemperatur und Erhöhung des Substratabstands vom Plasma führen jeweils zu einer Vergröberung der Schichtoberfläche und umgekehrt. Bei konstant gehaltenen sonstigen Bedingungen führt eine Erhöhung der Plasmaenergie auch zu Polymerschichten mit einer höheren chemischen Beständigkeit. Normalerweise arbeitet man mit einer Energieeinkopplung von 100 bis 6000, vorzugsweise von 200 bis 1000 W, stellt den Arbeitsdruck auf Werte zwischen 5 und 0,01, vorzugsweise 1 bis 0,025, mbar ein und die Substrattemperatur zwischen 20 und 200°C, vorzugsweise zwischen 20 und 120°C.

Zur Unterstützung der Schichtabscheidung kann eine Vorspannung (Bias) an das Substrat durch direkten Kontakt oder kapazitiv angelegt werden. Die Vorspannung kann gepulst oder ungepulst betrieben werden, wobei im gepulsten Fall monopolare oder bipolare Pulsung möglich ist. Die Pulsfrequenz ist in weiten Grenzen variierbar. Zweckmäßigerweise wählt man eine Pulsfrequenz zwischen 1 KHz und 100 MHz, vorzugsweise zwischen 20 KHz und 50 MHz, insbesondere zwischen 50 KHz und 20 MHz. Aus konstruktionsbedingten Gründen sind Pulsfrequenzen unter 27 MHz, z.B. eine Radiofrequenz von 13,56 MHz vorteilhaft.

Die zur Abscheidung einer Polymerschicht bestimmter Stöchiometrie, bestimmter physikalischer Eigenschaften und bestimmter Topographie erforderlichen Monomerzusammensetzungen und Prozeßparameter werden anhand von Vorversuchsreihen, ermittelt. Hierbei werden systematisch Plasmapolymerisationsversuche mit wechselnden Monomeren und Monomerzusammensetzungen und variierten Prozeßparametern ausgeführt und die stöchiometrischen und physikalischen Daten der dabei erhaltenen Polymerabscheidungen gemessen. Man erhält auf diese Weise für jede Monomerkombination die Eigenschaften der Polymerschichten als Funktion der Prozeßparameter, die man z.B. in Form von Eichkurven darstellen kann aus denen das für den Aufbau einer erfindungsgemäßen Plasmapolymerschicht mit beispielsweise einem bestimmten Elastizitätsgradienten erforderliche Regelprogramm für die Prozeßbedingungen entnommen werden kann.

Die stöchiometrische Zusammensetzung der Plasmapolymerschichten kann in bekannter Weise durch XPS-Analyse ermittelt werden. Die Bestimmung der Härte und Elastizität kann ebenfalls nach bekannten Methoden durchgeführt werden: Die Härtebestimmung erfolgt beispielsweise nach dem in P.Plein, "Plasmapolymerisation",(1989), Seiten 112-114 beschriebenen Verfahren, bei dem die Kraft, die auf eine Diamantspitze zur Erzeugung eines Kratzers in der zu beurteilenden Fläche ausgeübt werden muß, als Meßgröße dient, die anhand von Eichmessungen die Ermittlung der Härte der geprüften Fläche gestattet. Das Verfahren ist relativ störanfällig, hat aber bei Ausführung unter möglichst konstant gehaltenen Bedingungen die für die hier auszuführenden Vorversuche erforderliche Genauigkeit. Die Bestimmung der Elastizität kann nach einer ebenfalls in P.Plein, "Plasmapolymerisation",(1989), Seiten 108-110, zitierten, von K.Taube offenbarten (Seminarvortrag vom 25.11.1987, Philips-Forschungslaboratorium, Hamburg, "Messung der mechanischen Eigenschaften von dünnen Schichten) Meßmethode ausgeführt werden. Bei dieser wird eine Diamantspitze auf die Schicht mit einer solchen Kraft aufgesetzt, daß sie zwar bis zu einer gewissen Tiefe (nicht über 20 % der Schichtdicke) eindringt, daß sich aber keine plastische Verformung der Oberfläche ergibt. Dann wird die Aufsetzkraft sinusförmig moduliert und die entsprechenden Veränderungen in der Eindringtiefe gemessen. Aus den Werten der Kraftänderung und der Eindringtiefe kann der Elastizitätsmodul berechnet werden.

Das für die Erzeugung der erfindungsgemäßen Verschleißschutzschicht erforderliche Plasma kann ein gepulstes oder ungepulstes Mikrowellen-Plasma mit oder ohne Magnetfeldunterstützung (ECR), oder ein durch Hoch-oder Mittelfrequenz, insbesondere durch Radiofrequenz (z.B. 13,56 MHz), angeregtes oder durch Hohlkathoden-Anregung aufgebautes Plasma sein. Besonders bevorzugt ist der Einsatz eines Mikrowellenplasmas, weil damit die höchsten Abscheidungsraten erzielt werden können. Zur Ausführung eines simultanen oder nachgeschalteten Sputterprozesses eignet sich insbesondere das Verfahren des gepulsten oder ungepulsten Magnetron-Sputterns. Weitere Gegenstände der vorliegenden Erfindung sind die mit einer erfindungsgemäßen Verschleißschutzschicht versehenen Objekte und deren Verwendung als Bauelemente in technischen Geräten, insbesondere in mechanischen Kraftübertragungseinrichtungen.

Die folgenden Ausführungsbeispiele veranschaulichen die Erzeugung erfindungsgemäßer Verschleißschutzschichten.

### Ausführungsbeispiele

### Beispiel 1

In einem Vakuum-Rezipient mit Mikrowellenquelle und justierbarem und drehbaren Substrathalter wird ein Getriebezahnrad aus Polyetheretherketon (PEEK), dessen Oberfläche durch Plasmaätzung mit Sauerstoff gereinigt worden ist, (30 sec. bei 600 W Mikrowellenleistung und 100 sccm Sauerstoff-Fluß) unter ständiger Drehung im Bereich der Zähne unter folgenden Bedingungen beschichtet.

Nach Einlaß von 400 sccm gasförmigem HMDS(O) wird ein Plasma mit 500 W Mikrowellenleistung gezündet. Nach einer Polymerisationsdauer von 10 Minuten wird der HMDS(O)-Anteil im Gasstrom im Verlauf von 5 Minuten gleichmäßig auf 0 zurückgeregelt und im gleichen Zeitraum dem Gasstrom Acetylen, gleichmäßig steigend von 0 auf 100 Vol.-% zugemischt. Während dieses Zeitraumes wird die Mikrowellenleistung von 600 auf 800 W erhöht. Nach Beendigung des Konzentrationsänderungsprogramms der Monomergase wird die Polymerisation noch 10 Minuten mit dem erreichten Endfluß von 200 sccm Acetylen fortgesetzt.

Danach wird das erfindungsgemäß beschichtete Zahnrad dem Rezipienten entnommen. Es weist im Bereich der Zähne eine erfindungsgemäße 16 µm dicke Verschleißschutzschicht auf, bestehend aus einer Stützschicht und einer darauf abgeschiedenen sehr harten, porenfreien Kohlenstoff-Deckschicht.
Die Stützschicht weist in der Basisebene einen Kohlenstoffgehalt von 30 Atom-%, einen Siliciumgehalt von 40 Atom-%, einen Sauerstoffgehalt von 20 Atom-% und einen Wasserstoffgehalt von 10 Atom-% auf. Sie weist, gemessen über ihre Dicke, einen positiven Gradienten des Kohlenstoffgehalts auf, der in den Kohlenstoffgehalt der Deckschicht von 90 Atom-% mündet. Die erfindungsgemäße Schutzschicht zeigt ausgezeichnete Resistenz gegen Gleit-, Schwing- und Abrasivverschleiß sowie gegen Schlagverschleiß. Sie ist außerdem sehr hart und entsprechend kratzfest und zeigt gute Affinität zu Schmiermitteln.

### Beispiel 2

Das Beispiel 1 wird wiederholt mit dem Unterschied, daß in dem Zeitraum nach Abschluß des Konzentrationsänderungsprogramms der Monomergase während der Fortsetzung der Plasmapolymerisation mit 100 Vol.-% Acetylen simultan eine PVD-Abscheidung unter Verwendung eines Titan-Targets ausgeführt wird.

Die so erhaltene erfindungsgemäße Schutzschicht enthält in der Deckschicht 10 Atom-% Titan in Form von i-C(Ti). Sie zeigt eine noch etwas höhere Resistenz gegen Abrasion und eine deutlich höhere Gleitverschleißbeständigkeit als die in Beispiel 1 hergestellte Schicht.

## Patentansprüche

1. Kombinierte Verschleißschutzschicht für Bauelemente aus verschleißanfälligen Substraten, aus Kunststoffen oder weichen Metallen, bestehend aus einer verschleißfesten Deckschicht und einer zwischen Substrat und Deckschicht liegenden Stützschicht aus einem Plasmapolymer, das aus einem Monomergas oder einem Monomergas-Gemisch, bestehend aus einer oder mehreren gasförmigen siliciumorganischen Verbindungen und/oder aliphatischen und/oder aromatischen Kohlenstoffverbindungen und gegebenenfalls weiteren, Dotierungselemente enthaltenden Verbindungen, abgeschieden wurde,
**dadurch gekennzeichnet,**
**daß** die Deckschicht eines oder mehrere der Elemente Kohlenstoff, Stickstoff, Silicium oder Bor enthält, wobei der Anteil des Kohlenstoffs, des Stickstoffs oder des Bors, oder - sofern mehr als eines dieser Elemente vorhanden ist - die Summe der Anteile dieser Elemente mindestens 30 Atom-% beträgt, und daß-die Stützschicht einen quasi-stetigen, d.h. in Form einer geschlossenen oder vielstufigen Kurve ohne festigkeitsrelevante Unstetigkeitsstelle darstellbaren, Übergang des Elastizitätsmoduls von dem Wert der Basisebene der Stützschicht auf den Wert der Deckschicht aufweist und damit über ihre Dicke einen Übergang von der auf dem verschleißanfälligen Substrat aufliegenden Basisebene, die aus einem Plasmapolymerisat besteht, das bezüglich seines Elastizitätsmoduls, seiner Härte und seiner Verformbarkeit mit dem Material des Substrats eine zur Erzielung einer guten Haftung ausreichende Übereinstimmung aufweist, auf Eigenschaften der Deckschicht vermittelt.

2. Kombinierte Verschleißschutzschicht gemäß Anspruch 1, **dadurch gekennzeichnet, daß** der Anteil des Kohlenstoffs, des Stickstoffs oder des Bors, oder - sofern mehr als eines dieser Elemente vorhanden ist - die Summe der Anteile dieser Elemente mindestens 40 Atom-%, beträgt.

3. Kombinierte Verschleißschutzschicht gemäß mindestens einem der Ansprüche 1 und 2, **dadurch gekennzeichnet, daß** die Schichten und Schichtebenen, weitere Elemente enthalten.

4. Kombinierte Verschleißschutzschicht gemäß Anspruch 3, **dadurch gekennzeichnet, daß** die Schichten und Schichtebenen als weitere Elemente Wasserstoff, Sauerstoff und/oder Metalle enthalten.

5. Kombinierte Verschleißschutzschicht gemäß mindestens einem der Ansprüche 1 bis 4 **dadurch gekennzeichnet, daß** die Deckschicht über 60 Atom-% Kohlenstoff und bis zu 40 Atom-% Stickstoff, Bor, Silicium und/oder Metalle enthält.

6. Kombinierte Verschleißschutzschicht gemäß mindestens einem der Ansprüche 1 bis 5 **dadurch gekennzeichnet, daß** die Stützschicht einen quasi-stetigen Übergang der Härte von dem Wert der Basisschicht auf den Wert der Deckschicht aufweist

7. Kombinierte Verschleißschutzschicht gemäß mindestens einem der Ansprüche 1 bis 6, **dadurch gekennzeichnet, daß** die Basisebene der Stützschicht aus einem Plasmapolymerisat besteht, das eine hohe Adhäsion zum Material des Substrats hat.

8. Kombinierte Verschleißschutzschicht gemäß mindestens einem der Ansprüche 1 bis 7, **dadurch gekennzeichnet, daß** zwischen der Oberfläche des Substrats und der Basisebene der Stützschicht eine zusätzliche haftvermittelnde Schicht vorhanden ist.

9. Kombinierte Verschleißschutzschicht gemäß mindestens einem der Ansprüche 1 bis 8, **dadurch gekennzeichnet, daß** die Stützschicht zumindest in einem Schichtebenen-Bereich direkt unterhalb der Deckschicht einen Gradienten ihrer stöchiometrischen Zusammensetzung aufweist, der in der stöchiometrischen Zusammensetzung der Deckschicht mündet.

10. Verfahren zur Erzeugung der kombinierten Verschleißschutzschicht des Anspruchs 1 durch Plasmapolymerisation, bei dem einem Plasma ein Monomergas oder ein Monomergas-Gemisch, bestehend aus einer oder mehreren gasförmigen siliciumorganischen Verbindungen und/oder aliphatischen und/oder aromatischen Kohlenstoffverbindungen und gegebenenfalls weiteren, Dotierungselemente enthaltenden Verbindungen zugeführt wird wobei es zur plasmainduzierten Abscheidung einer sich vernetzenden Polymerschicht kommt, **dadurch gekennzeichnet, daß** die Polymerisationsbedingungen und die Monomergas-Zusammensetzung so gewählt werden, daß sich in jeder beim Aufbau der Schicht erreichten Schichtebene die für den Ausbildung eines quasi-stetigen, d.h. in Form einer geschlossenen oder vielstufigen Kurve ohne festigkeitsrelevante Unstetigkeitsstelle darstellbaren, Übergangs des Elastizitätsmoduls und gegebenenfalls der Härte von dem Wert der Basisschicht auf den Wert der Deckschicht erforderliche stöchiometrische Zusammensetzung ergibt.

11. Verfahren gemäß Anspruch 10, **dadurch gekennzeichnet, daß** die Plasmapolymerisation nach Auftrag einer Haftvennittlungsschicht ausgeführt wird.

12. Verfahren gemäß mindestens einem der Ansprüche 10 und 11, **dadurch gekennzeichnet, daß** die Plasmapolymerisation nach einer Plasmafeinreinigung (Plasmaätzung) ausgeführt wird.

13. Verfahren gemäß mindestens einem der Ansprüche 10 bis 12, **dadurch gekennzeichnet, daß** die Plasmapolymerisation nach einer Plasmaaktivierung der Substratoberfläche ausgeführt wird.

14. Verfahren gemäß mindestens einem der Ansprüche 10 bis 13, **dadurch gekennzeichnet, daß** das dem Plasma zugeführte Gasgemisch Dotierungselemente enthaltenden Verbindungen umfaßt.

15. Verfahren gemäß mindestens einem der Ansprüche 10 bis 14, **dadurch gekennzeichnet, daß** zur Unterstützung der Schichtabscheidung eine ungepulste oder gepulste Vorspannung (Bias) an das Substrat durch direkten Kontakt oder kapazitiv angelegt wird.

16. Verfahren gemäß mindestens einem der Ansprüche 10 bis 15, **dadurch gekennzeichnet, daß** Metall- und Nichtmetalldotierungen der Verschleißschutzschicht durch eine mit dem Plasmapolymerisationsprozess parallel laufende oder anschließend daran ausgeführte PVD-Abscheidung erzeugt werden.

17. Objekte aus verschleißanfälligen Substraten wie Kunststoffen oder weichen Metallen, **dadurch gekennzeichnet, daß** sie eine Verschleißschutzschicht gemäß Anspruch 1 aufweisen.

18. Verwendung der Objekte des Anspruchs 17 als Bauelemente in technischen Geräten, insbesondere in mechanischen Kraftübertragungseinrichtungen.

## Claims

1. Combination anti-abrasion layer for components made of substrates susceptible to abrasion, of plastics or soft metals, consisting of an abrasion-resistant top layer and a supporting layer located between substrate and top layer and consisting of a plasma polymer, which has been deposited from a monomer gas or a monomer gas mixture consisting of one or more gaseous silicon-organic compounds and/or aliphatic and/or aromatic carbon compounds and, if appropriate, compounds containing further doping elements,
**characterized in that**
the top layer contains one or more of the elements comprising carbon, nitrogen, silicon and boron, the proportion of the carbon, of the nitrogen or of the boron or - if more than one of these elements is present - the sum of the proportions of these elements being at least 30% by atoms, and **in that** the supporting layer has a quasi-continuous transition, that is to say one which can be represented in the form of a closed or multi-stage curve without strength-relevant discontinuity, of the modulus of elasticity from the value of the base plane of the supporting layer to the value of the top layer and therefore, over its thickness, promotes a transition from the base plane, which rests on the substrate that is susceptible to abrasion and which consists of a plasma polymer which, with regard to its modulus of elasticity, its hardness and its deformability, has a conformity with the material of the substrate which is sufficient to achieve good adhesion, to the properties of the top layer.

2. Combination anti-abrasion layer according to Claim 1, **characterized in that** the proportion of the carbon, of the nitrogen or the boron or - if more than one of these elements is present - the sum of the proportions of these elements is at least 40% by atoms.

3. Combination anti-abrasion layer according to at least one of Claims 1 and 2, **characterized in that** the layers and layer planes contain further elements.

4. Combination anti-abrasion layer according to Claim 3, **characterized in that** the layers and layer planes contain hydrogen, oxygen and/or metals as further elements.

5. Combination anti-abrasion layer according to at least one of Claims 1 to 4, **characterized in that** the top layer contains more than 60% by atoms of carbon and up to 40% by atoms of nitrogen, boron, silicon and/or metals.

6. Combination anti-abrasion layer according to at least one of Claims 1 to 5, **characterized in that** the supporting layer has a quasi-continuous transition of the hardness from the value of the base layer to the value of the top layer.

7. Combination anti-abrasion layer according to at least one of Claims 1 to 6, **characterized in that** the base plane of the supporting layer consists of a plasma polymer which exhibits high adhesion to the material of the substrate.

8. Combination anti-abrasion layer according to at least one of Claims 1 to 7, **characterized in that** there is an additional adhesion-promoting layer between the surface of the substrate and the base plane of the supporting layer.

9. Combination anti-abrasion layer according to at least one of Claims 1 to 8, **characterized in that**, at least in a layer plane region directly underneath the top layer, the supporting layer has a gradient of its stoichiometric composition which ends in the stoichiometric composition of the top layer.

10. Process for producing the combination anti-abrasion layer of Claim 1 by means of plasma polymerisation, in which the plasma is fed with a monomer gas or a monomer gas mixture, consisting of one or more gaseous silicon-organic compounds and/or aliphatic and/or aromatic carbon compounds and, if appropriate, compounds containing further doping elements, plasma-induced deposition of a cross-linking polymer layer occurring, **characterized in that** the polymerisation conditions and the monomer gas composition are chosen such that, in each layer plane achieved during the construction of the layer, the result is the stoichiometric composition required for the formation of a quasi-continuous transition, that is to say one which can be represented in the form of a closed or multi-stage curve without strength-relevant discontinuity, of the modulus of elasticity and, if appropriate, of the hardness from the value of the base layer to the value of the top layer.

11. Process according to Claim 10, **characterized in that** the plasma polymerisation is carried out following the application of an adhesion-promoting layer.

12. Process according to at least one of Claims 10 and 11, **characterized in that** the plasma polymerisation is carried out following plasma fine cleaning (plasma etching).

13. Process according to at least one of Claims 10 to 12, **characterized in that** the plasma polymerisation is carried out following plasma activation of the substrate surface.

14. Process according to at least one of Claims 10 to 13, **characterized in that** the gas mixture supplied to the plasma comprises compounds containing doping elements.

15. Process according to at least one of Claims 10 to 14, **characterized in that**, in order to assist the layered deposition, an unpulsed or pulsed bias voltage is applied to the substrate by means of direct contact or capacitively.

16. Process according to at least one of Claims 10 to 15, **characterized in that** metal and non-metal doping of the anti-abrasion layer is produced by means of a PVD deposition running in parallel with the plasma polymerisation process or carried out after the latter.

17. Objects made of substrates susceptible to abrasion such as plastics or soft metals, **characterized in that** they have an anti-abrasion layer according to Claim 1.

18. Use of the objects of Claim 17 as components in technical appliances, in particular in mechanical force transmission devices.

## Revendications

1. Couche anti-usure composite pour des composants faits de substrats susceptibles d'usure en matières synthétiques ou en métaux doux, composée d'une couche de recouvrement résistante à l'usure et d'une couche d'appui, située entre le substrat et la couche de recouvrement, en polymère plasmatique qui a été séparé d'un gaz monomère ou d'un mélange de gaz monomère constitué d'un ou de plusieurs composés gazeux organiques en silicium et/ou d'un ou de plusieurs composés de carbone aliphatiques et/ou aromatiques et éventuellement d'autres composés qui contiennent des éléments dopants,
**caractérisée en ce que**
la couche de recouvrement contient un ou plusieurs des éléments que sont le carbone, l'azote, le silicium ou le bore ; la proportion du carbone, de l'azote ou du bore ou - dans la mesure où plus d'un de ces éléments est présent - la somme des proportions de ces éléments s'élève alors à au moins 30 % en atomes, et la couche d'appui présente une transition presque constante - c'est-à-dire représentable sous forme d'une courbe fermée ou à plusieurs étages sans point de discontinuité pour ce qui est de la solidité - du module d'élasticité depuis la valeur du plan de base de la couche d'appui jusqu'à la valeur de la couche de recouvrement, et fournit par conséquent sur son épaisseur une transition vers les propriétés de la couche de recouvrement depuis le plan de base reposant sur le substrat susceptible d'usure et composé d'un polymérisat plasmatique qui présente, pour ce qui est de son module d'élasticité, de sa dureté et de son aptitude à la déformation, une correspondance suffisante avec le matériau du substrat pour obtenir une bonne adhérence.

2. Couche anti-usure composite selon la revendication 1,
**caractérisée en ce que**
la proportion du carbone, de l'azote ou du bore ou - dans la mesure où plus d'un de ces éléments est présent - la somme des proportions de ces éléments s'élève à au moins 40 % en atomes.

3. Couche anti-usure composite selon au moins l'une des revendications 1 et 2,
**caractérisée en ce que**
les couches et les plans de stratification contiennent d'autres éléments.

4. Couche anti-usure composite selon la revendication 3,
**caractérisée en ce que**
les autres éléments que contiennent les couches et les plans de stratification sont l'hydrogène, l'oxygène et/ou des métaux.

5. Couche anti-usure composite selon au moins l'une des revendications 1 à 4,
**caractérisée en ce que**
la couche de recouvrement contient plus de 60 % en atomes de carbone et jusqu'à 40 % en atomes d'azote, de bore, de silicium et/ou de métaux.

6. Couche anti-usure composite selon au moins l'une des revendications 1 à 5,
**caractérisée en ce que**
la couche d'appui présente une transition presque continue de la dureté depuis la valeur de la couche de base jusqu'à la valeur de la couche de recouvrement.

7. Couche anti-usure composite selon au moins l'une des revendications 1 à 6,
**caractérisée en ce que**
le plan de base de la couche d'appui se compose d'un polymérisat plasmatique dont l'adhérence au matériau du substrat est élevée.

8. Couche anti-usure composite selon au moins l'une des revendications 1 à 7,
**caractérisée en ce qu'**
il y a une couche supplémentaire assurant l'adhérence entre la surface du substrat et le plan de base de la couche d'appui.

9. Couche anti-usure composite selon au moins l'une des revendications 1 à 8,
**caractérisée en ce que**
la couche d'appui présente au moins dans une zone du plan de stratification directement sous la couche de recouvrement un gradient - de sa composition stoechiométrique - qui aboutit à la composition stoechiométrique de la couche de recouvrement.

10. Procédé pour produire la couche anti-usure composite de la revendication 1 par polymérisation plasmatique, selon lequel on conduit à un plasma un gaz monomère ou un mélange de gaz monomère composé d'un ou de plusieurs composés gazeux organiques contenant du silicium et/ou d'un ou de plusieurs composés de carbone aliphatiques et/ou aromatiques et éventuellement d'autres composés qui contiennent des éléments dopants, d'où il résulte un dépôt - inducteur de plasma - d'une couche polymère qui se réticule,
**caractérisé en ce que**
les conditions de polymérisation et la composition du gaz monomère sont choisies de telle manière que, dans chaque plan de stratification obtenu lors de la constitution de la couche, on obtient la composition stoechiométrique nécessaire pour former une transition presque constante - c'est-à-dire représentable sous forme d'une courbe fermée ou à plusieurs étages sans point de discontinuité pour ce qui est de la solidité - du module d'élasticité et éventuellement une transition de la dureté depuis la valeur de la couche de base jusqu'à la valeur de la couche de recouvrement.

11. Procédé selon la revendication 10,
**caractérisé en ce que**
la polymérisation plasmatique est réalisée après l'application d'une couche assurant l'adhésion.

12. Procédé selon au moins l'une des revendications 10 à 11,
**caractérisé en ce que**
la polymérisation plasmatique est réalisée après une purification fine du plasma (gravure plasmatique).

13. Procédé selon au moins l'une des revendications 10 à 12,
**caractérisé en ce que**
la polymérisation plasmatique est réalisée après une activation plasmatique de la surface du substrat.

14. Procédé selon au moins l'une des revendications 10 à 13,
**caractérisé en ce que**
le mélange de gaz conduit au plasma comprend des composés qui contiennent des éléments dopants.

15. Procédé selon au moins l'une des revendications 10 à 14,
**caractérisé en ce que**
pour favoriser le dépôt de couche on applique au substrat, par contact direct ou de façon capacitive, une précontrainte (polarisation) pulsée ou non pulsée.

16. Procédé selon au moins l'une des revendications 10 à 15,
**caractérisé en ce que**
des dopages métalliques ou non métalliques de la couche anti-usure sont produits par un dépôt physique en phase gazeuse réalisé parallèlement ou ultérieurement au processus de polymérisation plasmatique.

17. Objets faits de substrats susceptibles d'usure comme des matières synthétiques ou des métaux doux,
**caractérisés en ce qu'**
ils présentent une couche anti-usure selon la revendication 1.

18. Utilisation des objets de la revendication 17 comme composants dans des appareils techniques, en particulier dans des installations mécaniques de transmission de forces.
